# FASCICULE DE BREVET EUROPEEN

(11) **EP 1 183 642 B1**
(45) Date de publication et mention de la délivrance du brevet: **23.10.2002**
(21) Numéro de dépôt: 00920849.7
(22) Date de dépôt: 19.04.2000
(51) Int. Cl.: G06K 19/077

(54) **DISPOSITIF A CIRCUIT INTEGRE SECURISE CONTRE DES ATTAQUES PROCEDANT PAR DESTRUCTION CONTROLEE D'UNE COUCHE COMPLEMENTAIRE**
INTEGRIERTE SCHALTKREISANORDNUNG WELCHE GEGEN ANGRIFFE DURCH KONTROLLIERTE ZERSTÖRUNG EINER KOMPLEMENTÄREN SCHICHT GESICHERT IST
INTEGRATED CIRCUIT DEVICE WHICH IS SECURED AGAINST ATTACKS RESULTING FROM CONTROLLED DESTRUCTION OF AN ADDITIONAL LAYER

(30) Priorité: 19.04.1999 FR 9904916
(43) Date de publication de la demande: 06.03.2002
(73) Titulaire: SCHLUMBERGER Systèmes, 92120 Montrouge (FR)
(72) Inventeur: BONVALOT, Béatrice, F-91440 Bures sur Yvette (FR); LEYDIER, Robert, F-91400 Orsay (FR)
(74) Mandataire: den Braber, Gerard Paul
(86) Numéro de dépôt international: FR0001031
(87) Numéro de publication internationale: WO00063836

(56) Documents cités:
- EP-A- 0 080 233
- DE-A- 19 741 889
- US-A- 5 682 296

## Description

La présente invention concerne des dispositifs à circuit intégré comportant une couche active et une couche complémentaire fixée à une face active de ladite couche active. La présente invention concerne en outre des cartes munies de tels dispositifs ainsi que des tranches de matériau semi-conducteur munies d'une pluralité de tels dispositifs.

Des dispositifs à circuit intégré précités sont notamment décrits dans les demandes internationales publiées sous les numéros WO-96/16378, WO-97/11442 et WO-99/12204. D'autres dispositifs sont décrits dans les demandes de brevet déposées en France sous les numéros FR-98/01305, FR-98/13029 et FR-99/00858 qui n'ont pas été rendues accessibles au public à la date de priorité de la présente demande.

Ces dispositifs sont destinés à traiter ou à stocker des données confidentielles en vue, par exemple, de la réalisation de transactions électroniques dans des domaines variés tels que les domaines de la santé, de la télévision dite à péage, de la téléphonie ou tels que le domaine bancaire.

A cet effet, les dispositifs comportent des mémoires volatiles et non volatiles de type ROM, RAM, EEPROM, Flash PROM ou RAM Ferromagnétique ainsi qu'une unité centrale de traitement ou CPU, qui gère et distribue, par l'intermédiaire de bus d'adresses et de données, lesdites données confidentielles.

En pratique, les dispositifs sont intégrés au sein d'un module électronique et reportés dans un corps de carte tel que défini dans les normes ISO 7816 et 14443 ou GSM 11.11 et 11.14. Par ailleurs, des plots de contact des dispositifs sont connectés à des plages de contact affleurantes à la surface du corps de carte, ou alors, à des bornes de contact d'une antenne noyée dans le corps de carte, ce qui permet aux cartes de communiquer avec le monde extérieur. Selon leur mode de fonctionnement, les cartes sont dites à contact, sans contact ou alors mixtes.

Grâce aux dispositifs selon l'invention, la sécurité des données stockées ou traitées dans les cartes est améliorée. En effet, les attaques physiques tendant à dissocier la couche complémentaire et la couche active pour un accès non destructif au circuit intégré ne sont plus possibles. Il en va de même et ce, pour certains modes de réalisation desdits dispositifs, des attaques dites en lumière dans lesquelles un rayonnement électromagnétique focalisé vient perturber le fonctionnement sécuritaire de la puce.

Toutefois, d'autres attaques peuvent être mises en oeuvre avec quelques chances de succès à l'encontre des dispositifs connus. Il s'agit d'attaques physiques qui procèdent par destruction contrôlée de la couche complémentaire et, notamment, d'attaques par polissage ou par gravure de ladite couche. A cause de ces attaques, des fraudeurs pourraient avoir accès à la face active d'un dispositif à circuit intégré sans dégradation dudit circuit, prendre alors connaissance de l'architecture de ce circuit et, éventuellement, mettre en oeuvre les attaques précédemment interdites, telles que les attaques en lumière, pour accéder aux données confidentielles.

Dans le cas d'attaques par polissage, un plateau tournant de polissage est amené parallèle au plan de la couche complémentaire. Ce plateau érode cette couche de manière contrôlée jusqu'au niveau de la face active.

Dans le cas d'attaques par gravure, différentes méthodes connues peuvent être mises en oeuvre. C'est le cas en particulier de la méthode dite RIE (Reactive Ion Etching) qui procède par voie sèche. Selon cette méthode, des espèces chimiques réactives sont créées au sein d'un plasma électriquement neutre puis adsorbées à la surface de la couche complémentaire d'un dispositif où elles forment une couche moléculaire de complexes chimiques. Des ions, fortement accélérés dans un champ électrostatique, sont alors dirigés perpendiculairement vers la couche complémentaire du dispositif et détruisent la couche moléculaire de complexes chimiques. La couche complémentaire ou, plus spécifiquement, une partie de cette couche ne comprenant pas les ouvertures destinées à permettre une connexion électrique aux plots de contact, est ainsi finalement détruite couche par couche, jusqu'au niveau de la face active.

Compte tenu de ce qui précède, un problème que se propose de résoudre l'invention est de sécuriser des dispositifs à circuit intégré comportant une couche active comprenant un matériau semi-conducteur ; un circuit intégré à une face active de ladite couche active, ledit circuit intégré comportant des éléments de circuit et au moins un plot de contact affleurant à ladite face active ; une couche complémentaire fixée à ladite face active, ladite couche complémentaire couvrant au moins partiellement ledit circuit intégré de ladite couche active, contre des attaques procédant par destruction contrôlée de la couche complémentaire.

Au regard du problème précité, la solution de l'invention a pour objet un dispositif caractérisé en ce qu'un trou est ménagé dans la couche complémentaire, ledit trou étant situé à l'aplomb d'au moins un élément de circuit.

Ainsi, la destruction de la couche complémentaire ne peut plus être contrôlée et l'élément de circuit situé à l'aplomb du trou est détruit.

Par ailleurs, l'invention a pour objet une carte comportant un corps de carte muni d'un dispositif selon l'invention, une tranche de matériau semi-conducteur munie d'une pluralité de dispositifs selon l'invention ainsi qu'un procédé de fabrication d'un tel dispositif.

L'exposé qui va suivre, et qui ne comporte aucun caractère limitatif, permettra de mieux comprendre la manière dont l'invention peut être mise en pratique. Cet exposé est rédigé au regard des dessins annexés, dans lesquels :
- la figure 1 montre, en perspective, un dispositif selon l'invention dont des plots de connexion sont connectés à des fils conducteurs ;
- la figure 2 montre, en coupe transversale éclatée, une première variante de réalisation d'un dispositif selon l'invention ;
- la figure 3 montre, en coupe transversale éclatée, une deuxième variante de réalisation d'un dispositif selon l'invention ;
- la figure 4 montre, en coupe transversale éclatée, une troisième variante de réalisation d'un dispositif selon l'invention ;
- la figure 5 montre, en coupe transversale éclatée, une quatrième variante de réalisation d'un dispositif selon l'invention ;
- la figure 6 montre, en coupe transversale éclatée, une cinquième variante de réalisation d'un dispositif selon l'invention ;
- la figure 7 montre, en coupe transversale éclatée, une sixième variante de réalisation d'un dispositif selon l'invention;
- la figure 8 montre, en coupe transversale éclatée, une septième variante de réalisation d'un dispositif selon l'invention ; et
- la figure 9 illustre, en perspective, la fabrication d'une tranche de matériau semi-conducteur munie d'une pluralité de dispositifs selon l'invention.

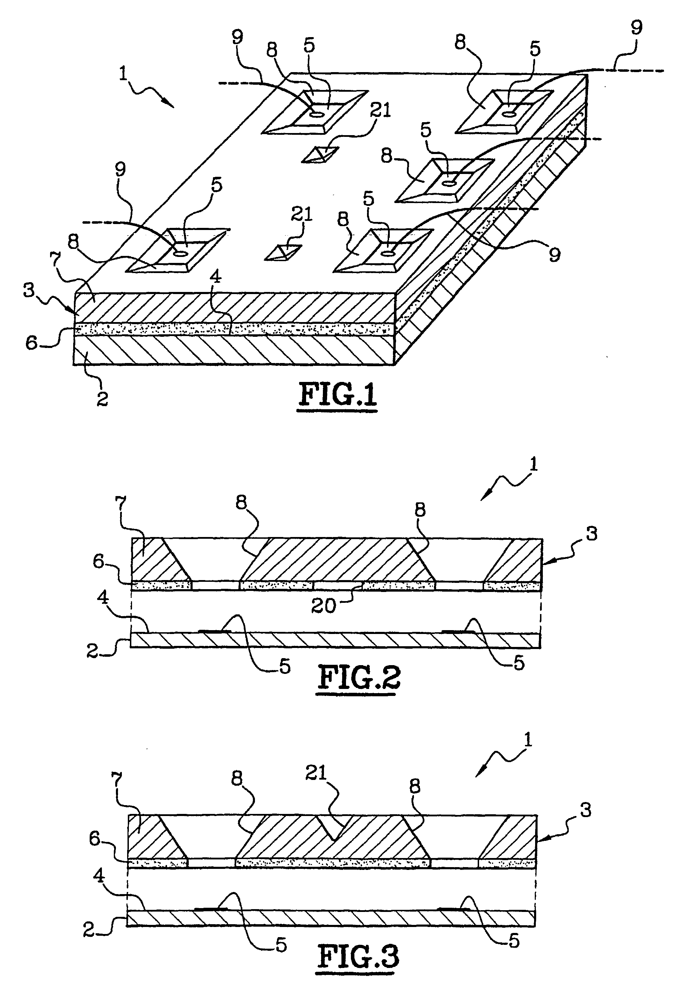

Ainsi que cela est montré à la figure 1, un dispositif 1 à circuit intégré selon l'invention comporte une couche active 2 et une couche complémentaire 3, lesdites couches 2 et 3 étant superposées. Ce dispositif 1 est sensiblement parallélépipèdique et rectangle de l'ordre de 200 µm d'épaisseur et de 2 mm de côté.

La couche active 2 est avantageusement amincie et son épaisseur, sensiblement constante, est comprise entre 10 et 80 µm, par exemple de l'ordre de 50 µm. Elle comprend une sous-couche de base formée d'un matériau semi-conducteur notamment du silicium et une sous-couche active à laquelle est intégré un circuit. La surface de la sous-couche active constitue la face active 4 du dispositif. Cette face active 4 montre des plots 5 de contact, par exemple au nombre de cinq. Elle montre par ailleurs différents éléments de circuit et notamment des mémoires volatiles ou non volatiles RAM, ROM, EEPROM, Flash PROM ou RAM Ferromagnétique, une unité centrale de traitement CPU ainsi que des lignes bus de données et d'adresses. Les plots 5 de contact ne sont pas, au sens de la présente invention, des éléments de circuit.

La couche complémentaire 3 a une épaisseur sensiblement constante, de l'ordre de 150 µm. Elle se compose d'une sous-couche de scellement 6 et d'une sous-couche de protection 7.

La sous-couche de scellement 6 est formée d'un matériau isolant par exemple d'un polyimide dont la fonction est de sceller la sous-couche de protection 7 à la face active 4 de la couche active 2. L'épaisseur de cette sous-couche 6 est sensiblement constante et de l'ordre de 10 µm.

La sous couche de protection 7 est formée d'un matériau semi-conducteur, par exemple d'un silicium monocristallin, et comprend éventuellement des éléments actifs, tels qu'une capacité, ou des éléments passifs, tels que des particules chimiques ayant notamment pour fonction de rendre impossibles les attaques en lumière quelle que soit la longueur d'onde utilisée. L'épaisseur de cette sous-couche 7 est sensiblement constante et de l'ordre de 140 µm.

Par ailleurs, la couche complémentaire 3 est percée d'ouvertures débouchantes 8 à l'aplomb des plots 5 de contact. Ces ouvertures 8 ont pour fonction de permettre une connexion électrique des plots 5 à des bornes d'antenne et/ou des plages de contact d'un dispositif électronique, en particulier, carte à puce, destiné à recevoir le dispositif. A la figure 1, on a représenté des moyens de connexion par des fils 9.

Selon l'invention, la couche complémentaire 3 comporte en outre un ou plusieurs trous 20, 21, 22, 23. Ces trous sont à l'aplomb d'un ou plusieurs éléments de circuit. Ils sont avantageusement non-débouchants en ce sens qu'ils ne constituent pas des ouvertures traversantes dans la couche complémentaire 3. De ce fait, un fraudeur ne peut pas mettre en oeuvre une attaque en lumière dirigée sur le ou les éléments de circuit à l'aplomb du trou. Dans certains modes de réalisation de l'invention, les trous non-débouchants sont borgnes en ce sens qu'ils débouchent sur l'une des faces de la couche complémentaire. Dans d'autres modes de réalisation de l'invention, les trous non débouchants ne sont pas borgnes et forment alors une cavité dans la couche complémentaire 3. La conformation des trous est quelconque par exemple cylindrique de section rectangulaire ou carrée ou conique de section rectangulaire ou carrée et éventuellement à base tronquée. Leur section, au niveau de la face de dessus de la couche complémentaire 3, définit une aire par exemple de l'ordre de 100 µm², et leur profondeur est supérieure ou égale à l'épaisseur de la couche 6 de scellement, c'est-à-dire supérieure ou égale à une valeur de 10 µm.

Les figures 2 à 8 présentent différents modes de réalisation d'un dispositif selon l'invention, dans lesquels, pour des raisons de simplicité de visualisation des trous, les couches active 2 et complémentaire 3 sont disjointes.

Dans le mode de réalisation de la figure 2, un trou 20 cylindrique droit est ménagé dans la sous-couche de scellement 6. Ce trou 20 est non débouchant et borgne dans la couche complémentaire 3. Il traverse toutefois la sous-couche 6 de scellement et s'associe sur la face 4 active de la couche 2 active.

Dans le mode de réalisation de la figure 3, un trou 21 pyramidal est ménagé dans la sous-couche 7 de protection. Ce trou 21 est non débouchant et borgne dans cette sous-couche 7 et, a fortiori, dans la couche complémentaire 3. Il s'ouvre à la face de la couche complémentaire 3 opposée à la face active 4 de la couche active 2.

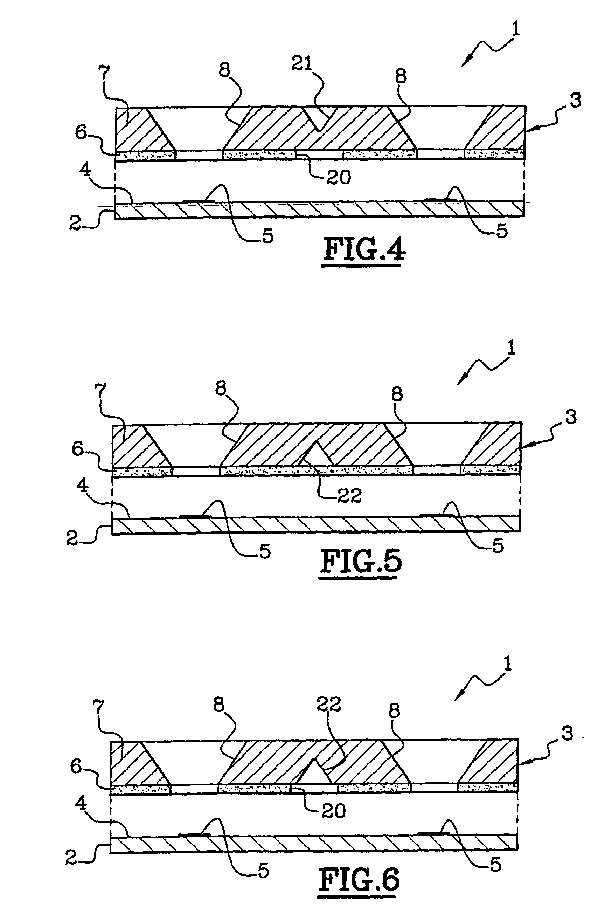

Dans le mode de réalisation de la figure 4, un trou 21 du type du trou présenté à la figure 3 est ménagé dans la sous-couche 7 de protection. Ce trou 21 est situé à l'aplomb d'un trou 20 du type de celui présenté à la figure 2 et en correspondance avec ce trou 21.

Dans le mode de réalisation de la figure 5, un trou 22 pyramidal est ménagé dans la sous-couche 7 de protection. Ce trou 22 est non débouchant et forme une cavité dans la couche complémentaire 3. Cette cavité est formée dans la sous-couche 7 de protection. Elle est limitée par la sous-couche 6 de scellement.

Dans le mode de réalisation montré à la figure 6, un trou 22 du type du trou présenté à la figure 5 est situé à l'aplomb et en correspondance avec un trou 20 ménagé dans la sous-couche de scellement 6 et du type du trou présenté à la figure 2. L'ensemble des trous 20, 22 forme un trou non débouchant borgne dans la couche complémentaire 3.

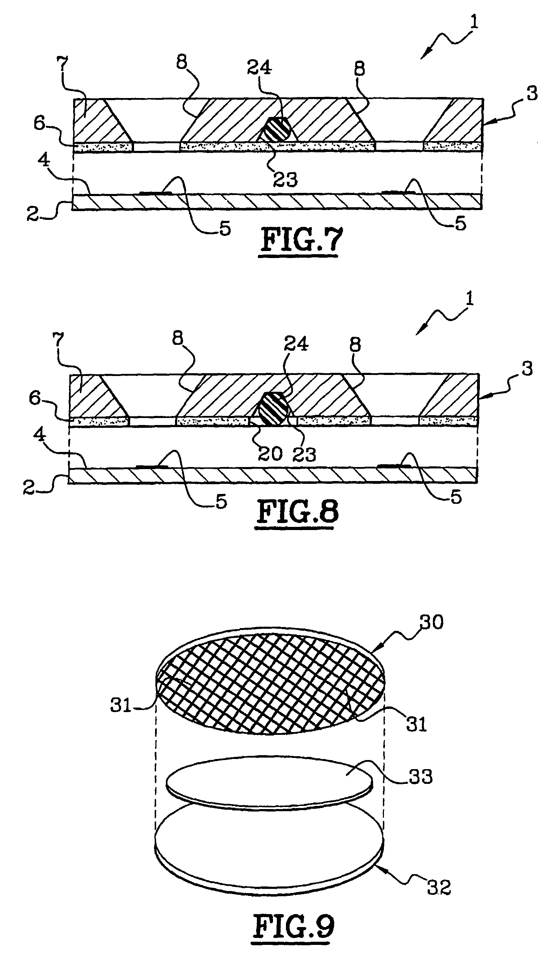

Dans le mode de réalisation de la figure 7, un trou 23 non débouchant est ménagé dans la sous-couche 7 complémentaire. Ce trou 23 est conique tronqué en sa base. Il définit une cavité dans laquelle est logée une particule 24 de dureté avantageusement supérieure ou égale à la dureté de la sous-couche active de la couche active 2. Cette particule 24 est par exemple une micro-bille sphérique dont les dimensions sont avantageusement ajustées pour que les parois du trou 23 bloquent ladite particule 24.

Dans le mode de réalisation de la figure 8, un trou 23, du type du trou présenté à la figure 7, est situé à l'aplomb et en correspondance avec un trou 20 du type de celui présenté à la figure 2. L'ensemble des trous 20 et 23 forme un trou non-débouchant borgne dans la couche complémentaire 3 dont l'ouverture débouche à la face active de la couche active 2. La particule 24 est, dans ce cas, avantageusement plus volumineuse que la particule 24 présentée à la figure 7. En effet, dans le mode de réalisation montré à la figure 8, la particule 24 est cette fois directement en contact avec l'élément de circuit qu'elle surplombe.

Ainsi, dans le cas où un fraudeur tenterait par exemple d'accéder au circuit intégré d'un dispositif selon l'invention du type de celui montré à la figure 2 au moyen d'une attaque RIE, les éléments de circuit situés à l'aplomb du trou 20 seraient détruits. En effet, l'attaque RIE procède couche moléculaire par couche moléculaire et ce, parallèlement à un plan : le plan de la couche complémentaire 3. Aussi, lorsque le niveau de la sous-couche 6 de scellement est atteint, des complexes chimiques sont formés, au niveau du trou 20, avec les éléments de circuit. Ces complexes sont alors détruits par bombardement ionique sans que le fraudeur puisse éviter cette destruction. Il n'est finalement pas possible d'obtenir des secrets conservés dans le circuit.

Il en va de même avec des dispositifs 1 du type de ceux montrés aux figures 3 à 8.

Toutefois, on notera que, lorsqu'un dispositif 1 selon l'invention est muni de trous du type 20, 22 ou 23, c'est-à-dire non apparents à la surface de la couche complémentaire 3, le fraudeur ne sait pas a priori si le dispositif comporte un trou et où serait situé ce trou. Il ne peut donc tenter d'éviter la destruction des éléments de circuit.

On notera d'autre part que, dans le cas où le trou comporte une particule du type 24 et dans le cas où le fraudeur procède par polissage, le plateau tournant de polissage repousse la micro-particule contre la face active et cette micro-particule, dont la dureté est supérieure ou égale à la dureté de la sous-couche active, détruit l'élément de circuit qu'elle surplombe, voire la couche active 2 rendant le circuit non utilisable pour l'obtention des secrets qu'il comporte.

Par ailleurs, pour la fabrication de dispositifs 1 selon l'invention, on utilise des tranches de matériau semi-conducteur appelées wafer.

A la figure 9, on a montré, en partie haute, un wafer classique 30 muni de quelques centaines voire quelques milliers de circuits intégrés 31. En partie basse de cette figure, on a montré une tranche 32 de silicium. Cette tranche 32 de silicium est destinée à être scellée au wafer 30 par une épaisseur de polyimide figurée sous la forme d'une tranche 33 intermédiaire entre le wafer 30 et la tranche 32.

En pratique, la tranche 32 est gravée des nombreuses ouvertures débouchantes non visibles sur les dessins destinées à former les ouvertures 8 des dispositifs 1 et des trous non débouchants selon l'invention.

D'autre part, une épaisseur de précurseur de polyimide sous forme non polymérisée est appliquée à la surface des circuits intégrés 31 du wafer classique 30 préalablement couverte d'un promoteur d'adhérence. L'ensemble wafer 30 et épaisseur de précurseur de polyimide 33 superposé, est porté à une température de l'ordre de 80 °C de manière que le précurseur de polyimide adhère suffisamment au wafer. Des trous du types des trous 20 ainsi que des ouvertures destinées à permettre une connexion électrique des plots, sont alors ménagés par gravure dans l'épaisseur 33 de précurseur.

Il suffit alors de reporter l'ensemble précité sur la tranche 32 et de soumettre ce nouvel ensemble à des cycles de température et de pression tels qu'on ait une polymérisation du polyimide avec scellement dudit nouvel ensemble, pour obtenir une tranche de matériau semi-conducteur muni d'une pluralité de dispositifs 1 selon l'invention.

Dans le cas où des particules 24 sont ajoutées dans des trous du type 23, ces particules 24 sont par exemple déposées sur la tranche 32 maintenue sensiblement horizontale. Ces particules tombent alors par gravité dans les trous 23. L'ensemble wafer classique et précurseur est alors reporté sur la tranche 32, verticalement, à la manière présentée en figure 9.

Une fois scellé, l'ensemble est aminci par micro-usinage et les dispositifs 1 selon l'invention sont découpés et détachés successivement et reportés au sein d'un module du type connu de l'état de la technique, ce module étant inséré dans un corps de carte pour l'obtention d'une carte à puce sécurisée selon l'invention ou d'un objet portatif du type carte à puce.

On notera que les trous sont avantageusement placés à des endroits différents d'un circuit intégré à un autre d'une même tranche de matériau semi-conducteur, et qu'ils sont avantageusement en nombre important et de différents types afin qu'un fraudeur ne puisse savoir à l'avance leur nombre et leur localisation.

## Revendications

1. Dispositif (1) à circuit intégré comportant:
une couche (2) active comprenant
un matériau semi-conducteur ;
un circuit intégré à une face (4) active de ladite couche (2) active, ledit circuit intégré comportant des éléments de circuit et au moins un plot (5) de contact affleurant à ladite face (4) active ;
une couche (3) complémentaire fixée à ladite face (4) active, ladite couche (3) complémentaire couvrant au moins partiellement ledit circuit intégré de ladite couche (2) active ;
**caractérisé en ce qu'**un trou (20, 21, 22, 23) est ménagé dans la couche (3) complémentaire, ledit trou (20, 21, 22, 23) étant situé à l'aplomb d'au moins un élément de circuit.

2. Dispositif selon la revendication 1, **caractérisé en ce que** la couche (3) complémentaire se compose d'une sous-couche (7) de protection et d'une sous-couche (6) de scellement, ladite sous-couche (7) de protection étant scellée à la face (4) active de la couche (2) active au moyen de la sous-couche (6) de scellement.

3. Dispositif selon l'une des revendications 1 ou 2, **caractérisé en ce que** le trou (20, 21, 22, 23) est un trou non-débouchant.

4. Dispositif selon la revendication 3, **caractérisé en ce que** le trou (20, 21) est un trou borgne.

5. Dispositif selon la revendication 3, **caractérisé en ce que** le trou (22, 23) forme une cavité non-débouchante de la couche (3) complémentaire.

6. Dispositif selon l'une des revendications 1 à 4, **caractérisé en ce que** le trou (21) s'ouvre à une face de la couche complémentaire (3) opposée à la face active de la couche (2) active.

7. Dispositif selon l'une des revendications I à 4, **caractérisé en ce que** le trou (20) s'ouvre sur la face (4) active de la couche (2) active.

8. Dispositif selon l'une des revendications précédentes, **caractérisé en ce que** le trou (20, 21, 22, 23) comporte une particule (24).

9. Dispositif selon la revendication 8, **caractérisé en ce que** cette particule (24) a une dureté supérieure ou égale à celle de la sous-couche active de la couche active (2).

10. Carte à puce ou objet portatif du type carte à puce comportant un corps muni d'un dispositif (1) selon l'une quelconque des revendications 1 à 9.

11. Tranche de matériau semi-conducteur, **caractérisée en ce qu'**elle est munie d'une pluralité de dispositifs (1) selon l'une des revendications 1 à 9.

## Patentansprüche

1. Vorrichtung (1) mit einem integrierten Schaltkreis, welche folgende Elemente umfasst:
eine aktive Schicht (2), welche folgende Elemente enthält:
ein Halbleitermaterial;
einen Schaltkreis, der in die aktive Seite (4) der besagten aktiven Schicht (2) integriert ist, wobei der besagte integrierte Schaltkreis Schaltkreiselemente und mindestens eine Kontaktstelle (5) umfasst, die in die besagte aktive Seite (4) versenkt sind;
eine zusätzliche Schicht (3), die an der besagten aktiven Seite (4) befestigt ist, wobei die besagte zusätzliche Schicht (3) zumindest teilweise den besagten integrierten Schaltkreis der besagten aktiven Schicht (2) bedeckt;
**dadurch gekennzeichnet, dass** in der zusätzlichen Schicht (3) ein Loch (20, 21, 22, 23) eingearbeitet ist, wobei das besagte Loch (20, 21, 22, 23) senkrecht über mindestens einem Schaltkreiselement liegt.

2. Vorrichtung nach Anspruch 1, **dadurch gekennzeichnet, dass** die zusätzliche Schicht (3) aus einer Schutzunterschicht (7) und einer Verschmelzungsunterschicht (6) besteht, wobei die besagte Schutzunterschicht (7) mit der aktiven Seite (4) der aktiven Schicht (2) mittels der Verschmelzungsunterschicht (6) verschmolzen ist.

3. Vorrichtung nach einem der Ansprüche 1 oder 2, **dadurch gekennzeichnet, dass** das Loch (20, 21, 22, 23) ein nicht durchlassendes Loch ist.

4. Vorrichtung nach Anspruch 3, **dadurch gekennzeichnet, dass** es sich bei dem Loch (20, 21) um ein blindes Loch handelt.

5. Vorrichtung nach Anspruch 3, **dadurch gekennzeichnet, dass** das Loch (22, 23) einen nicht durchlassenden Hohlraum der zusätzlichen Schicht (3) bildet.

6. Vorrichtung nach einem der Ansprüche 1 bis 4, **dadurch gekennzeichnet, dass** sich das Loch (21) zu einer der aktiven Seite der aktiven Schicht (2) gegenüberliegenden Seite der zusätzlichen Schicht (3) öffnet.

7. Vorrichtung nach einem der Ansprüche 1 bis 4, **dadurch gekennzeichnet, dass** sich das Loch (20) zur aktiven Seite (4) der aktiven Schicht (2) öffnet.

8. Vorrichtung nach einem der vorausgehenden Ansprüche, **dadurch gekennzeichnet, dass** das Loch (20, 21, 22, 23) ein Partikel (24) enthält.

9. Vorrichtung nach Anspruch 8, **dadurch gekennzeichnet, dass** dieses Partikel (24) eine mindestens genauso große oder eine größere Härte als die der aktiven Unterschicht der aktiven Schicht (2) aufweist.

10. Chip-Karte oder tragbarer Gegenstand vom Typ Chip-Karte mit einem mit einer Vorrichtung (1) nach irgendeinem der Ansprüche 1 bis 9 ausgestatteten Körper.

11. Halbleitermaterialscheibe, **dadurch gekennzeichnet, dass** sie mit einer Vielzahl an Vorrichtungen (1) nach einem der Ansprüche 1 bis 9 ausgestattet ist.

## Claims

1. Integrated circuit device (1) comprising :
- a film (2) including
- a semiconducting material ;
- a circuit integrated with one active face (4) of said active film(2), said integrated circuit comprising circuit elements and at least one contact block (5) flush with said active face (4) ;
- an additional film (3) fixed to said active face (4), said additional film (3) covering at least partially said integrated circuit of said active film (2) ;
**characterised in that** a hole (20, 21, 22, 23) is fitted in the additional film, said film (20, 21, 22, 23) being located flush with at least one circuit element.

2. Device according to claim 1, **characterised in that** the additional film (3) is formed of a protective sub-film (7) and a sealing sub-film (6), said protective sub-film (7) being sealed to the active face (4) of the active film (2) by means of the sealing sub-film (6).

3. Device according to one of claims 1 or 2, **characterised in that** the hole (20, 21, 22, 23) is a non-opening hole.

4. Device according to claim 3, charcterised in that the hole (20, 21) is a dummy hole.

5. Device according to claim 3, **characterised in that** the hole (22, 23) forms a non-opening cavity of the additional film (3).

6. Device according to one of claims 1 to 4, **characterised in that** the hole (21) opens onto one face of the additional film (3) opposite the active face of the active film (2).

7. Device according to one of claims 1 to 4, **characterised in that** the hole (20) opens onto the active face (4) of the active film (2).

8. Device according to one of the preceding claims, **characterised in that** the hole (20, 21, 22, 23) comprises a particle (24).

9. Device according to claim 8, **characterised in that** said particle (24) has a hardness greater than or equal that of the active sub-film of the active film (2).

10. Microchip card or portable object of the microchip type card comprising a body fitted with a device (1) according to any one of claims 1 to 9.

11. Semiconducting material section, **characterised in that** it is provided with a plurality of devices (1) according to one of claims 1 to 9.
